# EUROPÄISCHE PATENTSCHRIFT

(11) **EP 4 392 261 B1**
(45) Veröffentlichungstag und Bekanntmachung des Hinweises auf die Patenterteilung: **26.11.2025**
(21) Anmeldenummer: 22761539.0
(22) Anmeldetag: 08.08.2022
(51) Int. Cl.: B41J 2/21, H10K 99/00, H10K 71/13

(54) **VERFAHREN ZUM DRUCKEN WENIGSTENS EINER PRÄZISEN LINIE MITTELS INKJET-DRUCK**
METHOD FOR PRINTING AT LEAST ONE PRECISE LINE BY MEANS OF INKJET PRINTING
PROCÉDÉ D'IMPRESSION D'AU MOINS UNE LIGNE PRÉCISE PAR IMPRESSION À JET D'ENCRE

(30) Priorität: 23.08.2021 DE 102021121778
(43) Veröffentlichungstag der Anmeldung: 03.07.2024
(73) Patentinhaber: Notion Systems GmbH, 68723 Schwetzingen (DE)
(72) Erfinder: HAHN, David, 69126 Heidelberg (DE); SCHÖNEFELD, Jan, Dr., 69181 Leimen (DE)
(74) Vertreter: Dumlich, Heiko Alexander
(86) Internationale Anmeldenummer: PCT/EP2022/072270
(87) Internationale Veröffentlichungsnummer: WO 2023/025583

(56) Entgegenhaltungen:
- EP-A1- 0 984 303
- EP-A1- 2 250 028
- US-A1- 2015 015 626

## Beschreibung

Die Erfindung betrifft ein Verfahren zum Drucken wenigstens einer präzisen Linie mittels Inkjet-Druck.

Aus EP2250028A1 ist ein Verfahren zum Herstellen eines Wert- und/oder Sicherheitsdokuments bekannt, das einen monolithischen Dokumentenkörper umfasst, der aus mehreren Substratschichten zusammengefügt ist und bei dem auf mindestens eine der Substratschichten drucktechnisch ein Sicherheitsmerkmal aufgebracht ist, welches ein feines Linienmuster umfasst. Hierbei ist vorgesehen, dass das Sicherheitsdruckmuster in mindestens zwei Druckauszüge aufgeteilt wird, die einander ergänzen, so dass beim Drucken eines jeden der Druckauszüge jeweils ein Anteil von mindestens einer feinen Linie des feinen Linienmusters gedruckt wird und die mindestens zwei Druckauszüge mit mindestens zwei unterschiedlichen Druckverfahren gedruckt werden, wobei zumindest einer der mindestens zwei Druckauszüge mittels eines Druckpunkte verwendenden Druckverfahrens und zumindest ein anderer der mindestens zwei Druckauszüge mittels eines Druckverfahrens gedruckt werden, das den oder die Anteile der mindestens einen feinen Linie in Form einer glatten Kontur oder glatter Konturen druckt.

Aus EP 0 984 303 A1 ist ein Verfahren zum Herstellen eines Farbfilters bekannt. Das Verfahren umfasst die Schritte des Aufteilens eines Farbbereichs auf einem Substrat in eine Vielzahl von Druckbereichen und sukzessives Bedrucken der jeweiligen Druckbereiche mit Farbe durch ein Inkjet-System, wobei die Druckbereiche einen miteinander überlappenden Abschnitt aufweisen.

Verfahren zum Bedrucken eines Substrats mittels Inkjet-Druck sind in vielfältiger Ausgestaltung aus dem Stand der Technik bekannt und werden für zahlreiche Anwendungen verwendet, beispielsweise zum Bedrucken sowohl starrer, als auch flexibler Substrate. Besonders geeignet ist das Verfahren zum Inkjet-Druck für spezifische Anwendungen, die es erfordern, eine genaue Menge eines Druckmediums in genau vorgegebene Oberflächenbereiche des Substrats zu platzieren. Solche Anwendungen betreffen nicht nur den Druck von farbigen Druckmedien auf Substrate wie Papier, sondern beispielsweise auch den Druck von technischen oder medizinischen Sensorflächen, Reaktionsflächen für Medizinanwendungen, Pixelflächen von Displays, wie LCDs, TFTs, OLED-Displays oder E-Papier oder aber Druckvorgänge bei der Herstellung und Beschriftung von Leiterplatten.

Dabei ist es häufig erwünscht, besonders dünne, gleichförmige und optisch ansprechende Linien zu drucken, wozu zahlreiche Tropfen des Druckmediums hintereinander auf das Substrat aufgebracht werden. Um eine besonders dünne Linie zu ermöglichen, wird das Druckmedium und/oder die Substratoberfläche bevorzugt derart gewählt, dass sich ein besonders großer Kontaktwinkel zwischen der Oberfläche und dem darauf aufgebrachten Druckmedium ergibt bzw. das dazu gewählte Druckmedium und/oder Substrat haben zueinander aufgrund der jeweiligen Materialauswahl einen besonders großen Kontaktwinkel. Hierbei besteht jedoch das Problem, dass während des Drucks der Linie die halbkreisförmige Form des zuletzt aufgedruckten Tropfens am frisch gedruckten Ende der Linie zu einem Pumpdruck des flüssigen Druckmediums in der Linie führt, wodurch das bereits aufgedruckte Druckmedium die Linie entlang fließt, wodurch sich lokale Verbreiterungen der Linie aufgrund der großen Menge des Druckmediums in diesem Bereich ergeben. Dies führt zu einer optisch wahrnehmbaren Variation der Linienbreite und teils zu einer dreidimensionalen Abweichung oder einer Ungleichförmigkeit in wenigstens einer Raumrichtung entlang der Länge der gedruckten Linie.

Eine Lösung des Standes der Technik sieht zum Verhindern einer solchen Linienaufweitung sowie zum Vermeiden einer Abweichung oder einer Ungleichförmigkeit in wenigstens einer Raumrichtung vor, den Druckkopf während des Druckens schneller relativ zum Substrat zu bewegen und die Linie aus aneinander angeordneten Einzeldruckmediumstropfen schneller zu drucken, als das aufgedruckte Druckmedium auf dem Substrat entlang der Linie fließen kann. Hierdurch werden jedoch häufig Druckgeschwindigkeiten notwendig, die entweder technisch gar nicht realisierbar sind oder aber abermals aufgrund der extrem hohen Druckgeschwindigkeit zu einem unsauberen Druckergebnis und dabei insbesondere zu einer mangelnden Gleichförmigkeit der gedruckten Linie bis hin zu unerwünschten Unterbrechungen der Linie führen.

Der Erfindung liegt daher die Aufgabe zugrunde, ein Verfahren zum Drucken wenigstens einer präzisen Linie mittels Inkjet-Druck zu schaffen, das einen Druck einer besonders dünnen, präzisen und über die Länge gleichförmigen Linie ohne eine Abweichung oder eine Ungleichförmigkeit in wenigstens einer Raumrichtung sowie ohne unerwünschte Unterbrechungen ermöglicht.

Das erfindungsgemäße Verfahren zum Drucken wenigstens einer präzisen Linie mittels Inkjet-Druck sieht als Verfahrensschritte zunächst ein Bereitstellen eines zu bedruckenden Substrats und nachfolgend ein Drucken einer ersten Drucklage auf die Substratoberfläche vor, wozu wenigstens eine Druckkopfdüse und die Substratoberfläche relativ zueinander entlang einer Düsenbahn bewegt werden und wobei die Druckkopfdüse jeweils mehrere Druckmediumtropfen unmittelbar aufeinanderfolgend entlang der Düsenbahn zu einem Linienabschnitt druckt und nachfolgend eine Drucklücke ohne Druckmedium auf der Substratoberfläche freilässt, um ein Fließen von Druckmedium entlang des Linienabschnitts zu reduzieren oder sogar weitestgehend zu verhindern. Anschließend erfolgt ein technisch unterstütztes Antrocknen des Druckmediums der ersten Drucklage bevor eine weitere Drucklage gedruckt wird, sodass wenigstens neu auf das angetrocknete Druckmedium gedrucktes weiteres Druckmedium der nachfolgenden Drucklage mit dem angetrockneten Druckmedium nicht mehr verläuft und/oder sodass flüssiges Druckmedium der darauffolgenden Drucklage mit dem angetrockneten Druckmedium im Wesentlichen den gleichen Kontaktwinkel bildet wie vollständig getrocknetes Druckmedium. Nachfolgend erfolgt ein Drucken der wenigstens einen weiteren Drucklage durch ein Bewegen einer Druckkopfdüse und der Substratoberfläche relativ zueinander entlang der Düsenbahn, wobei die Druckkopfdüse jeweils mehrere Druckmediumtropfen unmittelbar aufeinanderfolgend zu einem weiteren Linienabschnitt druckt und wobei der in der weiteren Drucklage gedruckte weitere Linienabschnitt unmittelbar angrenzend oder sich überschneidend mit einem entlang der Düsenbahn vorhergehenden und/oder nachfolgenden, in einer vorherigen Drucklage gedruckten und bereits angetrockneten Linienabschnitt angeordnet wird.

Der Erfinder hat erkannt, dass durch einen Druck einer Linie in wenigstens zwei Drucklagen sowie durch den Druck jeweils nur eines Linienabschnitts in einer der Drucklagen ein starkes Fließen von Druckmedium entlang der bereits gedruckten Linie vermieden werden kann, wodurch vorteilhaft der Druck einer besonders dünnen und gleichförmigen Linie ermöglicht wird. Zudem ist bei dem erfindungsgemäßen Verfahren keine starke Erhöhung der Druckgeschwindigkeit notwendig, sodass nach wie vor eine präzise Tropfenplatzierung des Druckmediums beim Drucken möglich bleibt, was abermals die Qualität der gedruckten Linie optisch und/oder funktional erhöht.

Ein Druck einer präzisen Linie gemäß der Erfindung ist ein Auftrag von Druckmedium auf die Substratoberfläche in einer Weise, dass sich nach dem Abschluss des Druckvorgangs, insbesondere nach dem Druck einer letzten Drucklage, eine Aneinanderreihung von einzelnen Druckmediumtropfen ergibt, die zueinander ununterbrochen sind und/oder eine gleichförmige, glatte und/oder nicht-wellige Kante zu dem benachbarten unbedruckten Substrat aufweist. Dabei ist eine Linie bevorzugt lediglich aus entlang der Düsenbahn hintereinander angeordneten Druckmediumtropfen gebildet, während die Linie weiterhin bevorzugt keine nebeneinander platzierten Druckmediumtropfen umfasst. Darüber hinaus ist jedoch auch ein Druck einer Linie auf mehreren parallel zueinander angeordneten Druckdüsenbahnen denkbar, wobei dann bei den fertig gedruckten Linien mehrere Druckmediumtropfen, insbesondere bis zu vier Druckmediumtropfen, nebeneinander angeordnet sind. Weiterhin bevorzugt ist die Linie dabei gerade. Daneben ist aber auch ein gekrümmter bzw. gegenüber der Düsenbahn verwinkelter Verlauf der Linie denkbar, wobei jedoch ein besseres Druckergebnis erzeugt werden kann, wenn die Linie parallel zu der Düsenbahn und insbesondere bevorzugt entlang bzw. unmittelbar auf einer Düsenbahn verläuft.

Neben einer freigestellten Linie wird unter einer präzisen Linie im Sinne der Erfindung aber auch eine Linie verstanden, die den Rand einer bedruckten Fläche bildet, insbesondere da ein präziser Rand einer solchen Fläche häufig technisch notwendig und/oder von einem Benutzer erwünscht ist. Dabei kann dann die gesamte Fläche aus einzelnen, aneinander liegenden präzisen Linien gebildet sein oder aber die gesamte Fläche lediglich an wenigstens einem Rand und bevorzugt an allen Rändern eine präzise Linie aufweisen.

Erfindungsgemäß erfolgt der Druck der wenigstens einen präzisen Linie mittels Inkjet-Druck, wobei wenigstens ein Druckmedium mittels eines Druckkopfes mit wenigstens einer Druckkopfdüse und bevorzugt mittels einer Reihe von zueinander beabstandeten Druckkopfdüsen tropfenweise auf die Substratoberfläche aufgetragen wird, wobei dieser Auftrag bevorzugt vollständig berührungslos erfolgt. Die Druckmediumtropfen werden dabei nacheinander aus wenigstens einer Druckkopfdüse ausgestoßen, wobei bevorzugt alle Druckmediumtropfen gleich groß sind und/oder ein gleichbleibendes Volumen aufweisen.

Das Druckmedium, das als Tropfen beim Bedrucken auf das Substrat aufgebracht wird, kann grundsätzlich eine beliebige Flüssigkeit sein und zu beliebigen Zwecken dienen. Das Druckmedium kann beispielsweise auf einem wässrigen oder nicht-wässrigen Lösemittel basieren und zudem beliebige weitere, funktionale Komponenten aufweisen, beispielsweise Farbstoffe und Pigmente, aber auch chemisch und/oder biochemisch aktive Substanzen. Weiterhin bevorzugt weist das Druckmedium elektrisch leitfähige Substanzen auf und/oder ist zum Bilden elektrisch leitfähiger Strukturen, insbesondere zum Bilden von Leiterbahnen, vorgesehen. Besonders bevorzugt handelt es sich bei dem Druckmedium um eine Drucktinte bzw. eine Farbpigmentlösung. Alternativ kann das Druckmedium jedoch auch lösemittelfrei sein und/oder aushärtbar bzw. polymerisierbar sein. Besonders bevorzugt handelt es sich bei dem Druckmedium um eine UVhärtbare Tinte und/oder um einen Lack, insbesondere einen Lötstopplack oder einen leitfähigen Lack, beispielsweise einen silbernanopartikelbasierten Lack, der weiterhin bevorzugt keine Lösemittel aufweist und durch Polymerisation gehärtet wird.

Zum Bedrucken ist wenigstens ein Druckkopf vorgesehen, der relativ zu dem zu bedruckenden Substrat bewegt werden kann, sodass verschiedene Positionen des Substrats bedruckbar sind. Dabei kann sowohl der Druckkopf feststehend sein und das Substrat bewegt werden, als auch das Substrat feststehend sein und der Druckkopf bewegt werden. Grundsätzlich weist der Druckkopf wenigstens eine Druckkopfdüse zur Abgabe von Tropfen oder eines Strahls des Druckmediums auf, wobei bevorzugt zahlreiche Druckkopfdüsen am Druckkopf in einer Reihe und besonders bevorzugt dabei äquidistant zueinander angeordnet sind. Zudem können die Druckkopfdüsen auch in mehreren Reihen, insbesondere in einer Druckrichtung hintereinander und/oder lateral zueinander versetzt, am Druckkopf angeordnet sein.

Die unter dem Bereich der Druckkopfdüsen liegende Substratoberfläche während des Druckens und bevorzugt während einer einzelnen Überfahrt des Druckkopfes relativ zur Substratoberfläche wird als Druckerkopfbahn bezeichnet, während die senkrechte Projektion jeder einzelnen Druckkopfdüse auf die Oberfläche des Substrats einer bei dem Bedrucken vollzogenen Bewegungsbahn als Düsenbahn bezeichnet wird. Entsprechend wird die Düsenbahn nicht zwingend physisch als Linie auf dem Substrat abgebildet, sondern ist zunächst eine fiktive Verlaufsbahn. Würde jedoch eine Druckdüse während einer Linearbewegung über dem maximalen Druckbereich durchgehend ein Druckmedium abgeben, so würde die Düsenbahn mittels des Druckmediums auf der Oberfläche des Substrats als Linie wiedergegeben. Dabei kann die Düsenbahn grundsätzlich sowohl linear verlaufen, als auch einen beliebigen anderen, nicht-linearen Verlauf aufweisen. Ein Druckkopf mit mehreren, in einer Reihe angeordneten Druckkopfdüsen erzeugt bei einer einzelnen Überfahrt des Substrats mehrere fiktive Düsenbahnen über der Substratoberfläche, wobei der Abstand zwischen den Düsenbahnen der nativen Lateralauflösung des Druckkopfes entspricht.

Erfindungsgemäß druckt eine Druckkopfdüse mehrere Druckmediumtropfen aufeinanderfolgend entlang einer Düsenbahn zu einem Linienabschnitt, wobei der Abstand der einzelnen abgegebenen Druckmediumtropfen auf der Oberfläche des Substrats erfindungsgemäß wenigstens so gewählt wird, dass sich die noch flüssigen Druckmediumtropfen auf der Oberfläche des Substrats berühren und zu einer gemeinsamen Linie verlaufen können. Besonders bevorzugt wird der Abstand aufeinanderfolgend abgegebener Druckmediumtropfen derart gewählt, dass eine durchgehende Linie gleichbleibender Dicke gedruckt wird, wozu der Abstand der Abgabe einzelner Druckmediumtropfen aus der Druckkopfdüse bevorzugt kleiner als der Durchmesser, besonders bevorzugt kleiner als 90%, ganz besonders kleiner als 75 % und insbesondere bevorzugt kleiner als 50 % des Durchmessers des Druckmediumtropfens auf der Substratoberfläche ist.

Weiterhin bevorzugt gibt der Druckkopf und insbesondere eine Druckkopfdüse bei dem Drucken in zueinander gleichen Abständen entlang der Düsenbahn bzw. in Bezug zu der Oberfläche des Substrats jeweils einen einzelnen Druckmediumtropfen ab, sodass eine besonders gleichmäßige Linie gebildet wird. Aus den mehreren, sich auf der Substratoberfläche wenigstens teilweise verbindenden Druckmediumtropfen wird ein Linienabschnitt gebildet, wobei der Linienabschnitt bevorzugt entlang eines Teils einer Düsenbahn und/oder einer Druckerkopfbahn gebildet wird. Entsprechend ist ein Linienabschnitt bevorzugt ausschließlich aus mehreren, hintereinander angeordneten, in einer Drucklage erzeugten und/oder miteinander verbundenen Druckmediumtropfen gebildet.

Das Substrat kann grundsätzlich aus einem beliebigen Material gebildet sein und eine beliebige Form aufweisen, wobei das Substrat bevorzugt eine ebene, bedruckbare Oberfläche aufweist und besonders bevorzugt generell flach, insbesondere als Platte, Bogen, Blatt oder Folie, gebildet ist. Dabei kann das Substrat sowohl starr, als auch flexibel sein. Weiterhin kann das Substrat aus einem Fasermaterial, aus Holz, aus Papier, aus Kunststoff und/oder aus einem Verbundwerkstoff, insbesondere einem Schichtverbundwerkstoff, gebildet sein. Besonders bevorzugt handelt es sich bei dem Substrat um eine Leiterplatte bzw. um ein PCB und weist dabei bevorzugt Leiterbahnen auf wenigstens einem Höhenniveau gegenüber der restlichen Oberfläche des Substrats auf, sodass der Druck auf eine strukturierte, insbesondere wenigstens Leiterbahnen aufweisende Oberfläche erfolgt.

Weiterhin kann die zu bedruckende Oberfläche des Substrats unbehandelt sein. Bevorzugt ist die zu bedruckende Oberfläche des Substrats jedoch modifiziert, insbesondere physikalisch und/oder chemisch verändert, und/oder weist eine Oberflächenbeschichtung auf, insbesondere um einen besonders großen Kontaktwinkel mit dem Druckmedium sicherzustellen, was in besonders effizienter Weise den Druck einer besonders dünnen und präzisen Linie unterstützt.

Erfindungsgemäß erfolgt der Druck in wenigstens zwei Drucklagen, wobei in einer ersten Drucklage wenigstens ein Linienabschnitt und bevorzugt mehrere Linienabschnitte gedruckt werden. Die erste Drucklage wird dabei bevorzugt vollständig während einer Überfahrt des Druckkopfes bzw. in einer Druckkopfbahn gebildet. Weiterhin bevorzugt fährt der Druckkopf in der ersten Drucklage alle in dieser Drucklage zu bedruckenden Positionen der Substratoberfläche entlang einer Düsenbahn kontinuierlich ab. Bei dem Druck mehrerer Linien, insbesondere zueinander paralleler und zugleich voneinander beabstandeter Linien, auf der Substratoberfläche kann grundsätzlich sowohl zunächst ein Druck aller Drucklagen einer einzelnen Linie gedruckt werden, als auch ein vollständiger Druck der ersten Drucklage aller Linien, gefolgt von dem Druck der weiteren Drucklage oder Drucklagen aller Linien. Ebenfalls bevorzugt erfolgt der Druck aller Drucklagen identisch zueinander, insbesondere mit der gleichen Druckgeschwindigkeit und/oder mit zueinander identischen Druckparametern. Obwohl ein Druck der präzisen Linie in beliebig vielen Drucklagen denkbar ist, ist ein Druck in maximal drei Drucklagen und insbesondere in genau zwei Drucklagen bevorzugt, da dies einen besonders schnellen Druck ermöglicht.

Erfindungsgemäß erfolgt ein Antrocknen des Druckmediums der ersten Drucklage auf der Substratoberfläche bevor die zweite Drucklage gedruckt wird und bevorzugt erfolgt ein solches Antrocknen zwischen dem Druck aller Drucklagen. Unter dem Antrocknen wird ein Verdunsten des Lösemittels und/oder ein Abbinden, ein Polymerisieren und/oder ein Verfestigen wenigstens einer Substanz des Druckmediums und insbesondere des gesamten Druckmediums verstanden, sodass wenigstens das neu auf das angetrocknete Druckmedium gedruckte weitere Druckmedium der nachfolgenden Drucklage mit dem angetrockneten Druckmedium nicht mehr verläuft und/oder sodass flüssiges Druckmedium der darauffolgenden Drucklage mit dem angetrockneten Druckmedium im Wesentlichen den gleichen Kontaktwinkel bildet wie vollständig getrocknetes Druckmedium. Entsprechend wird ein Härten bzw. ein Anhärten auch als Antrocknen verstanden. Bevorzugt beträgt der Anteil des polymerisierten und/oder gehärteten Druckmediums nach dem Antrocknen wenigstens 30 %, besonders bevorzugt wenigstens 50 %, ganz besonders bevorzugt wenigstens 80 % und insbesondere bevorzugt wenigstens 90 %. Weiterhin ist die Viskosität der Oberfläche des Druckmediums oder des gesamten Druckmediums nach dem Antrocken bzw. dem Anhärten so hoch, dass ein Fließen im Wesentlichen nicht mehr möglich ist. Entsprechend dient der Verfahrensschritt des Antrocknens bzw. des Anhärtens im Wesentlichen der Formverfestigung des frisch gedruckten Druckmediums. Erfindungsgemäß erfolgt das Antrocknen technisch unterstützt, beispielsweise durch Erwärmen, eine Umgebungsluftzirkulation, einen Gas- bzw. Luftstrahl oder durch Bestrahlen, insbesondere mit UV- oder IR-Licht. Ebenso kann ein Härten bzw. Polymerisieren technisch unterstützt, beispielsweise durch Erwärmen, eine Umgebungsluftzirkulation, einen Gas- bzw. Luftstrahl oder durch Bestrahlen, insbesondere mit UV- oder IR-Licht, erfolgen.

Erfindungsgemäß wird wenigstens in der ersten Drucklage und bevorzugt in jeder Drucklage bis auf in der letzten Drucklage wenigstens nach einem Linienabschnitt und bevorzugt wenigstens zwischen zwei Linienabschnitten eine Drucklücke ohne Druckmedium freigelassen. Ganz besonders bevorzugt wird zwischen allen Linienabschnitten einer Linie eine Drucklücke freigelassen, insbesondere während des Drucks der ersten Drucklage. Bevorzugt wird zum Erzeugen der Drucklücke wenigstens ein Druckmediumtropfen beim Drucken ausgelassen, sodass ein Abschnitt der Substratoberfläche nicht mit dem Druckmedium bedruckt wird und in dieser Drucklage frei bleibt. Dabei setzt eine Drucklücke die zu druckende Linie bevorzugt fort, nur ohne ein Aufdrucken von Druckmedium.

Schließlich ist zum Bilden der präzisen Linie bei dem erfindungsgemäßen Verfahren vorgesehen, dass in der weiteren Drucklage, in jeder weiteren Drucklage und/oder wenigstens in der letzten Drucklage ein weiterer Linienabschnitt gedruckt wird. Dabei wird der Druck des weiteren Linienabschnitts entlang der Düsenbahn bzw. räumlich unmittelbar angrenzend oder sich überschneidend mit einem entlang der Düsenbahn vorhergehenden und/oder nachfolgenden, in einer vorherigen Drucklage gedruckten Linienabschnitt angeordnet, sodass der in einer vorherigen Drucklage gedruckten Linienabschnitt und der weitere Linienabschnitt wenigstens einen längeren ununterbrochenen Linienabschnitt und bevorzugt alle Linienabschnitte die gesamte ununterbrochene Linie bilden.

Unter einer unmittelbar angrenzenden Anordnung des weiteren Linienabschnitts an einen zuvor gedruckten Linienabschnitt wird insbesondere eine Anordnung des ersten Druckmediumtropfens an das Ende des zuvor gedruckten Linienabschnitts verstanden, bei der eine Überschneidung des Linienendes und des neu gedruckten Drucktropfens so groß ist, dass der Kontaktbereich beider Linienabschnitte nicht sichtbar ist und/oder dass die beiden Linienabschnitte eine optisch ununterbrochene Linie bilden und/oder dass beide aneinander liegenden Endbereiche beider Linienabschnitte eine identische Linienbreite aufweisen. Dazu ist bevorzugt eine Überschneidung des Endes der zuvor gedruckten Linie und des ersten Druckmediumtropfens des weiteren Linienabschnitts zwischen 10 % und 90 %, besonders bevorzugt zwischen 25 % und 75 % und ganz besonders bevorzugt zwischen 40 % und 60 % des Durchmessers eines Druckmediumtropfens vorgesehen.

Unter einer sich überschneidenden Anordnung des zuvor gedruckten Linienabschnitts und eines weiteren Linienabschnitts wird dagegen eine Anordnung verstanden, bei der wenigstens der Anfang eines weiteren gedruckten Linienabschnitts, insbesondere der halbkreisförmige Teil des Anfangs, vollständig auf dem wenigstens angetrockneten Ende eines bereits gedruckten Linienabschnitts platziert wird. Dadurch ergibt sich der Vorteil, dass das flüssige Druckmedium nicht mit der Substratoberfläche, sondern mit der Oberfläche des angetrockneten Druckmediums in Kontakt gelangt und damit einen anderen Kontaktwinkel als mit der Substratoberfläche bildet, was zu einer Reduzierung des Pumpdrucks und somit des Druckmediumflusses in Richtung auf den Anfang des noch flüssigen Linienabschnitts und/oder zu einer optischen Verbesserung des Druckergebnisses führen kann. Bevorzugt gibt es eine Überschneidung eines angetrockneten Endes eines zuvor gedruckten Linienabschnitts und eines gerade gedruckten weiteren Linienabschnitts um wenigstens einen Druckmediumtropfen bzw. um dessen Durchmesser.

Eine vorteilhafte Ausgestaltung des erfindungsgemäßen Verfahrens zum Drucken wenigstens einer präzisen Linie sieht vor, dass der Druck jedes Druckmediumtropfens in ein Feld eines (virtuellen) Rasters aus Druckpositionen in Zeilen und Spalten erfolgt, wobei sich der oder die in der ersten Drucklage gedruckten Linienabschnitte und/oder die darauf folgende Drucklücke jeweils über mehrere hintereinander angeordnete Felder einer Zeile erstrecken und sich bevorzugt alle in einer Drucklage gedruckten Druckmediumtropfen zu einem Linienabschnitt und/oder sich alle Linienabschnitte aller Drucklagen zu einer Linie verbinden.

Grundsätzlich können die Linienabschnitte und/oder die Drucklücken jeweils beliebig lang sein, wobei jedoch der Effekt des entlang des Linienabschnittes fließenden Druckmediums und der damit einhergehenden Vergrößerung der Welligkeit sich mit zunehmender Länge des Linienabschnittes verstärkt. Entsprechend ist es vorteilhaft, wenn jeder gedruckte Linienabschnitt und/oder jede Drucklücke zwischen 1 und 100, bevorzugt zwischen 2 und 50, besonders bevorzugt zwischen 2 und 10 und ganz besonders bevorzugt zwischen 2 und 5 Felder lang sind oder aus einer entsprechenden Anzahl an Druckmediumtropfen gebildet sind. Dabei können alle Linienabschnitte und/oder alle Drucklücken jeweils eine identische Länge aufweisen oder aber jeweils individuell lang sein. Bevorzugt sind die Linienabschnitte einer Drucklage alle gleich lang und/oder ebenfalls bevorzugt sind alle Drucklücken einer Drucklage gleich lang. Besonders bevorzugt sind die Linienabschnitte und die Drucklücken einer Drucklage nicht gleich lang und ganz besonders bevorzugt sind die Linienabschnitte einer Drucklage, insbesondere wenigstens der ersten Drucklage, länger als die Drucklücken dieser Drucklage.

Insbesondere ist vorteilhaft, wenn jeder gedruckte Linienabschnitt zwischen 1 und 100, bevorzugt zwischen 2 und 50, besonders bevorzugt zwischen 2 und 10, ganz besonders bevorzugt zwischen 2 und 5 und insbesondere bevorzugt zwischen 3 und 5 Felder lang ist oder aus einer entsprechenden Anzahl an Druckmediumtropfen gebildet ist und/oder wenn jede Drucklücke zwischen 2 und 100, bevorzugt zwischen 2 und 50, besonders bevorzugt zwischen 2 und 10, ganz besonders bevorzugt zwischen 2 und 5 und insbesondere bevorzugt zwischen 3 und 5 Felder lang ist oder aus einer entsprechenden Anzahl an Druckmediumtropfen gebildet ist, wodurch ein Fließen des Druckmediums entlang der Linie und eine damit einhergehende Aufweitung oder Welligkeit der Linie besonders gut vermieden werden kann.

Grundsätzlich kann das Längenverhältnis zwischen den Linienabschnitten und den Drucklücken einer Drucklage beliebig gewählt werden, wobei jedoch bevorzugt ist, dass die Linienabschnitte der ersten Drucklage gleich lang sind wie die Drucklücken dieser Drucklage und/oder dass die Linienabschnitte der letzten Drucklage länger sind als die Drucklücken dieser Drucklage. Insbesondere ist dabei bevorzugt, dass die Linienabschnitte der ersten Drucklage zwischen 3 und 5 Druckmediumtropfen und/oder die Drucklücken zwischen 2 und 3 Drucklücken lang sind. Weiterhin ist bevorzugt, dass die Linienabschnitte der letzten Drucklage zwischen 3 und 6 Druckmediumtropfen lang sind. Weiterhin ist bevorzugt, dass die Drucklücken der letzten Drucklage kürzer sind als die Drucklücken der ersten Drucklage und/oder dass die Linienabschnitte der ersten Drucklage kürzer sind als die Linienabschnitte der letzten Drucklage.

Bei einer vorteilhaften Ausgestaltung des erfindungsgemäßen Verfahrens zum Drucken wenigstens einer präzisen Linie erfolgt der vollständige Druck der präzisen Linie in zwei Drucklagen. Alternativ oder zusätzlich füllen die weiteren Linienabschnitte der letzten Drucklage, insbesondere einer zweiten Drucklage, die verbleibenden Drucklücken zwischen zuvor gedruckten Linienabschnitten vollständig. Durch einen entsprechenden Druck kann eine präzise Linie besonders schnell und mit der kleinstmöglichen Anzahl der Überfahrten des Druckkopfes gedruckt werden.

Gemäß einer bevorzugten Weiterbildung des erfindungsgemäßen Verfahrens zum Drucken wenigstens einer präzisen Linie wird der weitere Linienabschnitt bzw. werden die weiteren Linienabschnitte jeweils überschneidend mit dem entlang der Düsenbahn vorhergehenden und dem nachfolgenden, in einer vorherigen Drucklage gedruckten Linienabschnitt gedruckt, sodass beide Enden des weiteren Linienabschnitts auf zuvor aufgedrucktes und bereits angetrocknetes Druckmedium treffen. Dabei ist besonders bevorzugt, dass die Überschneidung zwischen einem zuvor gedruckten Linienabschnitt und einem weiteren Linienabschnitt einer weiteren Drucklage zwischen 1 und 3, besonders bevorzugt zwischen 1 und 2 und ganz besonders bevorzugt genau 1 Feld oder eine entsprechende Anzahl an Druckmediumtropfen beträgt.

Obwohl grundsätzlich nur ein Teil des Drucks und/oder ein Teil einer Linie aus einzeln gedruckten Linienabschnitten gebildet sein kann, ist es bevorzugt, dass der vollständige Druck einer präzisen Linie und besonders bevorzugt der gesamten Oberfläche des Substrats in mehreren Drucklagen aus ersten und weiteren Linienabschnitten erfolgt. Zudem ist bevorzugt, dass das Drucken in allen Drucklagen und/oder aller Linienabschnitte mittels desselben Druckmediums, insbesondere einem härtbaren Lack, erfolgt, wozu ganz besonders bevorzugt in jeder Drucklage genau ein Druckkopf verwendet wird. Insbesondere bevorzugt erfolgt das Drucken aller Druckmediumtropfen einer Drucklage entlang einer Düsenbahn mittels derselben Druckkopfdüse und/oder die Linienabschnitte einer Düsenbahn werden in jeder Drucklage jeweils mit einer anderen Druckkopfdüse gedruckt.

Ein Ausführungsbeispiel des erfindungsgemäßen Verfahrens wird nachstehend mit Bezug auf die Zeichnungen näher erläutert. In den Figuren zeigen:
- Fig. 1: eine schematische Ansicht mehrerer auf eine Substratoberfläche gedruckter Linienabschnitte aus flüssigen Druckmediumtropfen,
- Fig. 2: eine schematische Ansicht der in Fig. 1 dargestellten Linienabschnitte nach dem Antrocknen des Druckmediums,
- Fig. 3a: eine schematische Ansicht mehrerer an die angetrockneten Linienabschnitte der Fig. 2 angrenzend gedruckter flüssiger Druckmediumtropfen,
- Fig. 3b: eine schematische Ansicht mehrerer mit den angetrockneten Linienabschnitten der Fig. 2 überschneidend gedruckter flüssiger Druckmediumtropfen,
- Fig. 3c: eine schematische Ansicht mehrerer mit den angetrockneten Linienabschnitten der Fig. 2 vollständig überschneidend gedruckter flüssiger Druckmediumtropfen, und
- Fig. 4: eine schematische Ansicht einer gedruckten präzisen Linie.

Bei einer Ausführung des Verfahrens zum Drucken einer präzisen, dünnen, gleichförmigen Linie 1 ohne eine Abweichung oder Ungleichförmigkeit in wenigstens einer Raumrichtung wird zunächst als Substrat für den Inkjet-Druck ein Papier bereitgestellt, das auf seiner Oberfläche eine Beschichtung aufweist, die einen großen Kontaktwinkel zwischen dem Substrat und der Drucktinte sicherstellt. Alternativ kann auch die Oberfläche einer Leiterplatte bedruckt werden, wobei dann die Drucktinte besonders bevorzugt ein Lötstopplack ist.

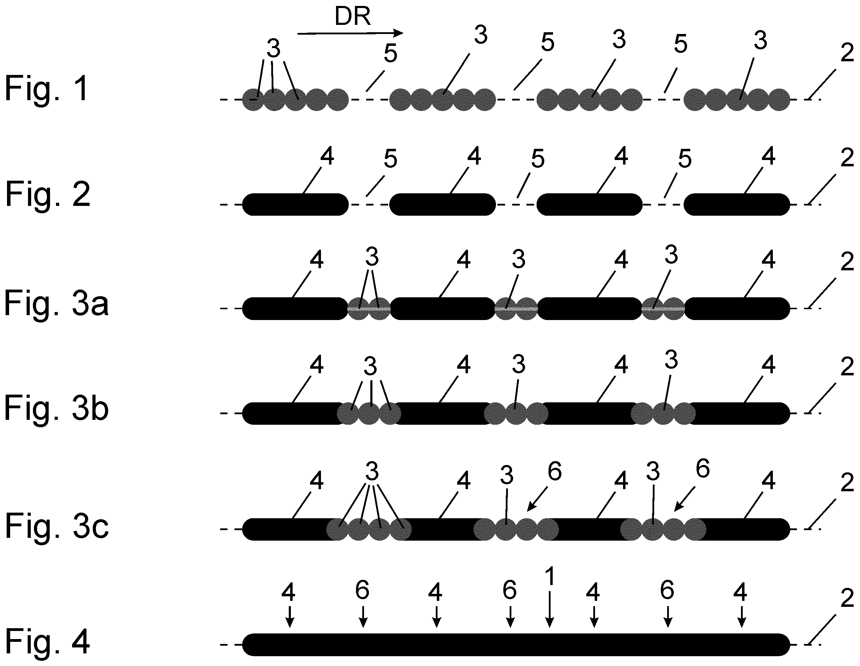

Nachfolgend wird das Substrat relativ zu einem Druckkopf mit wenigstens einer Drucckopfdüse entlang einer linearen Düsenbahn 2 bewegt, sodass die Druckkopfdüse während einer einzigen Überfahrt über jede bedruckbare Position auf der Substratoberfläche bewegt wird und sich eine Relativbewegung des Druckkopfes entlang einer Druckrichtung DR ergibt. Während dieser Relativbewegung entlang der Düsenbahn 2 gibt der Druckkopf durch die Druckdüse regelmäßig und an vorbestimmten Positionen einen einzelnen Drucktintentropfen 3 ab (siehe Fig. 1), wobei alle Drucktintentropfen 3 ein zueinander identisches Volumen haben. Der Druck dieser Drucktintentropfen 3 bildet die erste Drucklage.

Die jeweilige Position der Abgabe eines Drucktintentropfens 3 wird dabei so gewählt, dass zunächst mehrere Drucktintentropfen 3 unmittelbar nebeneinander auf die Substratoberfläche gelangen und durch das Verfließen auf der Substratoberfläche einen glatten Linienabschnitt 4 bilden, wobei nach einer vorbestimmten Anzahl an Drucktintentropfen 3 - in diesem Beispiel jeweils genau nach fünf Drucktintentropfen 3 - eine Drucklücke 5 freigelassen wird, die - in diesem Beispiel - eine Länge entlang der Düsenbahn 2 von zwei Drucktintentropfen 3 aufweist.

Die unmittelbar nebeneinander positionierten und flüssig auf die Substratoberfläche gelangenden Drucktintentropfen 3 der ersten Drucklage fließen jeweils zu einem Linienabschnitt 4 zusammen, der bereits eine gleichförmige Breite aufweist (siehe Fig. 2). Nachfolgend wird die Drucktinte antrocknen gelassen, wobei das in der Drucktinte enthaltene Lösemittel verdampfen gelassen wird oder die Drucktinte, insbesondere ein Lötstopplack, weitestgehend abbindet bzw. polymerisiert.

Anschließend wird der Druckkopf abermals an den Anfang der bereits in der ersten Drucklage abgefahrenen Düsenbahn 2 versetzt und eine zweite Drucklage gedruckt, was bevorzugt mit einer anderen Druckkopfdüse erfolgt als der Druck der ersten Drucklage. Dabei wird jedoch nur im Bereich von Positionen ein Drucktintentropfen 3 abgegeben, die beim Drucken der ersten Drucklage nicht bedruckt wurden und wo entsprechend eine Drucklücke 5 der ersten Drucklage vorgesehen wurde. Auch die in der weiteren Drucklage unmittelbar aneinander angrenzend auf die Substratoberfläche gedruckten Drucktintentropfen 3 verbinden sich abermals zu weiteren Linienabschnitten 6.

Dabei sieht eine erste Variante des Drucks der zweiten Drucklage vor, dass der jeweils erste und letzte Drucktintentropfen 3 eines weiteren Linienabschnitts 6 der zweiten Drucklage exakt neben das Ende des in der vorherigen Drucklage gedruckten Linienabschnitts 4 positioniert werden, sodass es zu keiner gezielten Überdeckung der beiden Linienabschnitte 4, 6 kommt, aber zugleich die Drucktinte so verläuft, dass an den Positionen, an denen die beiden Linienabschnitte 4, 6 der beiden Drucklagen aufeinanderstoßen, die Linie 1 eine gleichbleibende Dicke aufweist (siehe Fig. 3a). Eine Überdeckung wird dabei insbesondere soweit vermieden, wie es nicht zwingend für einen störungsfreien Anschluss der Linienabschnitte 4, 6 aneinander notwendig ist.

Weiterhin sieht eine zweite Variante des Drucks der zweiten Drucklage vor, dass der jeweils erste und letzte Drucktintentropfen 3 eines weiteren Linienabschnitts 6 der zweiten Drucklage so auf dem jeweiligen Ende des in der vorherigen Drucklage gedruckten Linienabschnitts 4 positioniert werden, sodass es eine Überdeckung der beiden Linienabschnitte 4, 6 um eine halbe Drucktintentropfenbreite gibt, wobei zugleich nach wie vor an den Positionen, an denen die beiden Linienabschnitte 4, 6 der beiden Drucklagen aufeinanderstoßen, die Linie 1 eine gleichbleibende Dicke aufweist (siehe Fig. 3b).

Eine dritte Variante des Drucks der zweiten Drucklage sieht dagegen vor, dass der jeweils erste und letzte Drucktintentropfen 3 eines weiteren Linienabschnitts 6 der zweiten Drucklage exakt das Ende des in der vorherigen Drucklage gedruckten Linienabschnitts 4 vollständig überdeckt (siehe Fig. 3c), wodurch ein besonders guter Anschluss geschaffen wird und zudem der neu gedruckte, noch flüssige Drucktintentropfen 3 mit bereits getrockneter Drucktinte und nur in geringem Umfang mit der Oberfläche des Substrats in Kontakt gelangt, wodurch in einfacher Weise ein nachfolgendes Fließen von Drucktinte entlang des neu gedruckten Linienabschnitts 6 verhindert wird.

Schließlich trocknen dann auch die in der zweiten Drucklage gedruckten Linienabschnitte 6 vollständig und es wird eine besonders präzise, dünne, gleichförmige Linie 1 ohne eine Abweichung oder eine Ungleichförmigkeit in wenigstens einer Raumrichtung erhalten, bei der keine Anschlussbereiche zwischen den in der ersten Drucklage gedruckten Linienabschnitten 4 und den in der zweiten Drucklage gedruckten Linienabschnitten 6 sichtbar ist (siehe Fig. 4).

### Bezugszeichenliste

- 1: Linie
- 2: Düsenbahn
- 3: Druckmediumtropfen
- 4: Linienabschnitt
- 5: Drucklücke
- 6: weiterer Linienabschnitt
- DR: Druckrichtung

## Patentansprüche

1. Verfahren zum Drucken wenigstens einer präzisen Linie (1) mittels Inkjet-Druck, mit den Schritten:
- Bereitstellen eines zu bedruckenden Substrats;
- Drucken einer ersten Drucklage auf die Substratoberfläche, wozu wenigstens eine Druckkopfdüse und die Substratoberfläche relativ zueinander entlang einer Düsenbahn (2) bewegt werden und wobei
- die Druckkopfdüse mehrere Druckmediumtropfen (3) unmittelbar aufeinanderfolgend entlang der Düsenbahn (2) zu einem Linienabschnitt (4) druckt und nachfolgend eine Drucklücke (5) ohne Druckmedium auf der Substratoberfläche freilässt, um ein Fließen von Druckmedium entlang des Linienabschnitts (4) zu reduzieren;
- technisches unterstütztes Antrocknen des Druckmediums der ersten Drucklage bevor eine weitere Drucklage gedruckt wird, sodass wenigstens neu auf das angetrocknete Druckmedium gedrucktes weiteres Druckmedium der nachfolgenden Drucklage mit dem angetrockneten Druckmedium nicht mehr verläuft und/oder sodass flüssiges Druckmedium der darauffolgenden Drucklage mit dem angetrockneten Druckmedium im Wesentlichen den gleichen Kontaktwinkel bildet wie vollständig getrocknetes Druckmedium;
- Drucken wenigstens einer weiteren Drucklage durch ein Bewegen einer Druckkopfdüse und der Substratoberfläche relativ zueinander entlang der Düsenbahn (2), wobei
- die Druckkopfdüse mehrere Druckmediumtropfen (3) unmittelbar aufeinanderfolgend zu einem weiteren Linienabschnitt (6) druckt, wobei
- der in der weiteren Drucklage gedruckte weitere Linienabschnitt (6) unmittelbar angrenzend oder sich überschneidend mit einem entlang der Düsenbahn (2) vorhergehenden und/oder nachfolgenden, in einer vorherigen Drucklage gedruckten Linienabschnitt (4) angeordnet wird.

2. Verfahren zum Drucken wenigstens einer präzisen Linie nach Anspruch 1,
**dadurch gekennzeichnet, dass**
- der Druck jedes Druckmediumtropfens (3) in ein Feld eines Rasters aus Druckpositionen in Zeilen und Spalten erfolgt, wobei
- sich der oder die in der ersten Drucklage gedruckten Linienabschnitte (4) und/oder die darauf folgende Drucklücke (5) jeweils über mehrere hintereinander angeordnete Felder einer Zeile erstrecken und
- sich alle in einer Drucklage gedruckten Druckmediumtropfen (3) zu einem Linienabschnitt (4, 6) und/oder sich alle Linienabschnitte (4, 6) aller Drucklagen zu einer Linie (1) verbinden.

3. Verfahren zum Drucken wenigstens einer präzisen Linie nach Anspruch 1 oder 2, **dadurch gekennzeichnet, dass** jeder gedruckte Linienabschnitt (4, 6) und/oder jede Drucklücke (5) zwischen 1 und 100, bevorzugt zwischen 2 und 50, besonders bevorzugt zwischen 2 und 10 und ganz besonders bevorzugt zwischen 2 und 5 Felder lang sind oder aus einer entsprechenden Anzahl an Druckmediumtropfen (3) gebildet sind.

4. Verfahren zum Drucken wenigstens einer präzisen Linie nach wenigstens einem der vorhergehenden Ansprüche, **dadurch gekennzeichnet, dass**
- jeder gedruckte Linienabschnitt (4, 6) zwischen 1 und 100, bevorzugt zwischen 2 und 50, besonders bevorzugt zwischen 2 und 10, ganz besonders bevorzugt zwischen 2 und 5 und insbesondere bevorzugt zwischen 3 und 5 Felder lang ist oder aus einer entsprechenden Anzahl an Druckmediumtropfen (3) gebildet ist und/oder dass
- jede Drucklücke (5) zwischen 2 und 100, bevorzugt zwischen 2 und 50, besonders bevorzugt zwischen 2 und 10, ganz besonders bevorzugt zwischen 2 und 5 und insbesondere bevorzugt zwischen 3 und 5 Felder lang ist oder aus einer entsprechenden Anzahl an Druckmediumtropfen (3) gebildet ist.

5. Verfahren zum Drucken wenigstens einer präzisen Linie nach wenigstens einem der vorhergehenden Ansprüche, **dadurch gekennzeichnet, dass**
- der vollständige Druck der präzisen Linie (1) in zwei Drucklagen erfolgt und/oder dass
- die weiteren Linienabschnitte (6) der letzten Drucklage, insbesondere einer zweiten Drucklage, die verbleibenden Drucklücken (5) zwischen zuvor gedruckten Linienabschnitten (4) wenigstens vollständig füllen.

6. Verfahren zum Drucken wenigstens einer präzisen Linie nach wenigstens einem der vorhergehenden Ansprüche, **dadurch gekennzeichnet, dass** der oder die weiteren Linienabschnitte (6) jeweils überschneidend mit dem entlang der Düsenbahn (1) vorhergehenden und dem nachfolgenden, in einer vorherigen Drucklage gedruckten Linienabschnitt (4) gedruckt wird, sodass beide Enden des weiteren Linienabschnitts (6) auf zuvor aufgedrucktes und bereits angetrocknetes Druckmedium treffen.

7. Verfahren zum Drucken wenigstens einer präzisen Linie nach wenigstens einem der vorhergehenden Ansprüche, **dadurch gekennzeichnet, dass** die Überschneidung zwischen einem zuvor gedruckten Linienabschnitt (4) und einem weiteren Linienabschnitt (6) einer weiteren Drucklage zwischen 1 und 3, besonders bevorzugt zwischen 1 und 2 und ganz besonders bevorzugt genau 1 Feld oder eine entsprechende Anzahl an Druckmediumtropfen (3) beträgt.

8. Verfahren zum Drucken wenigstens einer präzisen Linie nach wenigstens einem der vorhergehenden Ansprüche, **dadurch gekennzeichnet, dass** der vollständige Druck einer präzisen Linie (1) und bevorzugt der gesamten Oberfläche des Substrats in mehreren Drucklagen aus ersten und weiteren Linienabschnitten (4, 6) erfolgt.

9. Verfahren zum Drucken wenigstens einer präzisen Linie nach wenigstens einem der vorhergehenden Ansprüche, **dadurch gekennzeichnet, dass** das Drucken in allen Drucklagen und/oder aller Linienabschnitte (4, 6) mittels desselben Druckmediums, insbesondere einem härtbaren Lack, erfolgt.

10. Verfahren zum Drucken wenigstens einer präzisen Linie nach wenigstens einem der vorhergehenden Ansprüche, **dadurch gekennzeichnet, dass** das Drucken aller Druckmediumtropfen (3) einer Drucklage entlang einer Düsenbahn (2) mittels derselben Druckkopfdüse erfolgt und/oder dass die Linienabschnitte (4, 6) einer Düsenbahn in jeder Drucklage jeweils mit einer anderen Druckkopfdüse gedruckt werden.

## Claims

1. Method for printing at least one precise line (1) by means of inkjet printing, comprising the steps of:
- providing a substrate to be printed on;
- printing a first print layer onto the substrate surface, for which purpose at least one print head nozzle and the substrate surface are moved relative to each other along a nozzle path (2), and wherein
- the print head nozzle prints several printing-medium drops (3) in immediate succession along the nozzle path (2) to form a line portion (4) and subsequently leaves clear a printing gap (5) without printing medium on the substrate surface in order to reduce a flowing of printing medium along the line portion (4);
- technically assisted surface-drying the printing medium of the first print layer before an additional print player is printed, such that at least the additional printing medium of the subsequent print layer, which is printed onto the surface-dried printing medium, no longer runs with the surface-dried printing medium, and/or so that liquid printing medium of the subsequent print layer with the surface-dried printing medium substantially forms the same contact angle as completely dried printing medium;
- printing at least one additional print layer by moving a print head nozzle and the substrate surface relative to each other along the nozzle path (2), wherein
- the print head nozzle prints several printing-medium drops (3) in immediate succession to form an additional line portion (6), wherein
- the additional line portion (6) printed in the additional print layer is arranged immediately adjacent to or overlapping with a line portion (4) which precedes and/or comes after along the nozzle path (2) and which was printed in a prior print layer.

2. Method for printing at least one precise line according to claim 1, **characterized in that**
- each printing-medium drop (3) is printed in a field of a grid of printing positions in rows and columns, wherein
- the line portion(s) (4) printed in the first print layer and/or the following printing gap (5) each extend over several fields of a row arranged one after the other, and
- all printing-medium drops (3) printed in a print layer are connected to form a line portion (4, 6), and/or all line portions (4, 6) of all print layers are connected to form a line (1).

3. Method for printing at least one precise line according to claim 1 or 2, **characterized in that** each printed line portion (4, 6) and/or each printing gap (5) are between 1 and 100, preferably between 2 and 50, particularly preferably between 2 and 10, and very particularly preferably between 2 and 5 fields long or are formed from a corresponding number of printing-medium drops (3).

4. Method for printing at least one precise line according to at least one of the preceding claims, **characterized in that**
- each printed line portion (4, 6) is between 1 and 100, preferably between 2 and 50, particularly preferably between 2 and 10, very particularly preferably between 2 and 5, and in particular preferably between 3 and 5 fields long or is formed from a corresponding number of printing-medium drops (3), and/or **in that**
- each printing gap (5) is between 2 and 100, preferably between 2 and 50, particularly preferably between 2 and 10, very particularly preferably between 2 and 5, and in particular preferably between 3 and 5 fields long or is formed from a corresponding number of printing-medium drops (3).

5. Method for printing at least one precise line according to at least one of the preceding claims, **characterized in that**
- the complete printing of the precise line (1) takes place in two print layers, and/or **in that**
- the additional line portions (6) of the last print layer - in particular, a second print layer - at least completely fill the remaining printing gaps (5) between previously printed line portions (4).

6. Method for printing at least one precise line according to at least one of the preceding claims, **characterized in that** the additional line portion(s) (6) are each printed overlapping with the line portion (4) which precedes and which comes after along the nozzle path (1) and which was printed in a prior print layer, so that both ends of the additional line portion (6) meet the previously printed and already surface-dried printing medium.

7. Method for printing at least one precise line according to at least one of the preceding claims, **characterized in that** the overlap between a previously printed line portion (4) and an additional line portion (6) of an additional print layer is between 1 and 3, particularly preferably between 1 and 2, and very particularly preferably exactly 1 field or a corresponding number of printing-medium drops (3).

8. Method for printing at least one precise line according to at least one of the preceding claims, **characterized in that** the complete printing of a precise line (1) and preferably of the entire surface of the substrate takes place in several print layers of first and additional line portions (4, 6).

9. Method for printing at least one precise line according to at least one of the preceding claims, **characterized in that** the printing takes place in all print layers and/or all line portions (4, 6) by means of the same printing medium - in particular, a curable lacquer.

10. Method for printing at least one precise line according to at least one of the preceding claims, **characterized in that** all printing-medium drops (3) of a print layer are printed along a nozzle path (2) by means of the same print head nozzle, and/or **in that** the line portions (4, 6) of a nozzle path are each printed with a different print head nozzle in each print layer.

## Revendications

1. Procédé pour l'impression d'au moins un filet précis (1) au moyen d'une impression à jet d'encre, comprenant les étapes consistant à :
- fournir un substrat à imprimer ;
- imprimer une première couche d'impression sur la surface de substrat, au moins une buse de tête d'impression et la surface de substrat étant déplacées à cet effet l'une par rapport à l'autre le long d'une course de buse (2), et dans lequel
- la buse de tête d'impression imprime plusieurs gouttes de milieu d'impression (3) directement les unes après les autres le long de la course de buse (2) vers une section formant filet (4) et laisse ensuite un espace d'impression (5) sans milieu d'impression sur la surface de substrat afin de réduire un écoulement de milieu d'impression le long de la section formant filet (4) ;
- sécher par assistance technique le milieu d'impression de la première couche d'impression avant l'impression d'une autre couche d'impression, de sorte qu'au moins le milieu d'impression supplémentaire de la couche d'impression suivante et nouvellement imprimé sur le milieu d'impression séché ne s'étend plus avec le milieu d'impression séché et/ou de sorte que le milieu d'impression liquide de la couche d'impression suivante forme, avec le milieu d'impression séché, sensiblement le même angle de contact que le milieu d'impression complètement séché ;
- imprimer au moins une autre couche d'impression en déplaçant une buse de tête d'impression et la surface de substrat l'une par rapport à l'autre le long de la course de buse (2), dans lequel
- la buse de tête d'impression imprime plusieurs gouttes de milieu d'impression (3) directement les unes après les autres vers une autre section formant filet (6), dans lequel
- l'autre section formant filet (6) imprimée dans l'autre couche d'impression est disposée de manière directement adjacente ou en chevauchement avec une section formant filet (4) précédente et/ou suivante le long de la course de buse (2) et imprimée dans une couche d'impression précédente.

2. Procédé pour l'impression d'au moins un filet précis selon la revendication 1, **caractérisé en ce que**
- l'impression de chaque goutte de milieu d'impression (3) est effectuée dans un champ d'une trame de positions d'impression en lignes et en colonnes, dans lequel
- la ou les sections formant filets (4) imprimées dans la première couche d'impression et/ou l'espace d'impression (5) suivant s'étendent respectivement sur plusieurs champs d'une ligne disposés les unes derrière les autres, et
- toutes les gouttes de milieu d'impression (3) imprimées dans une couche d'impression se réunissent en une section formant filet (4, 6) et/ou toutes les sections formant filets (4, 6) de toutes les couches d'impression se réunissent en un filet (1).

3. Procédé pour l'impression d'au moins un filet précis selon la revendication 1 ou 2, **caractérisé en ce que** chaque section formant filet (4, 6) imprimée et/ou chaque espace d'impression (5) présentent une longueur comprise entre 1 et 100, de préférence entre 2 et 50, de manière particulièrement préférée entre 2 et 10 et de manière tout particulièrement préférée entre 2 et 5 champs, ou sont formés d'un nombre correspondant de gouttes de milieu d'impression (3).

4. Procédé pour l'impression d'au moins un filet précis selon au moins l'une des revendications précédentes, **caractérisé en ce que**
- chaque section formant filet (4, 6) imprimée présente une longueur comprise entre 1 et 100, de préférence entre 2 et 50, de manière particulièrement préférée entre 2 et 10, de manière tout particulièrement préférée entre 2 et 5 et de manière extrêmement préférée entre 3 et 5 champs ou est formée d'un nombre correspondant de gouttes de milieu d'impression (3) **et/ou en ce que**
- chaque espace d'impression (5) présente une longueur comprise entre 2 et 100, de préférence entre 2 et 50, de manière particulièrement préférée entre 2 et 10, de manière tout particulièrement préférée entre 2 et 5 et de manière extrêmement préférée entre 3 et 5 champs ou est formé d'un nombre correspondant de gouttes de milieu d'impression (3).

5. Procédé pour l'impression d'au moins un filet précis selon au moins l'une des revendications précédentes, **caractérisé en ce que**
- l'impression complète du filet précis (1) est effectuée en deux couches d'impression **et/ou en ce que**
- les autres sections formant filets (6) de la dernière couche d'impression, en particulier d'une seconde couche d'impression, remplissent au moins complètement les espaces d'impression (5) restants entre des sections formant filets (4) imprimées auparavant.

6. Procédé pour l'impression d'au moins un filet précis selon au moins l'une des revendications précédentes, **caractérisé en ce que** la ou les autres sections formant filets (6) sont imprimées respectivement en chevauchement avec la section formant filet (4) précédente le long de la course de buse (1) et avec la section formant filet suivante imprimée dans une couche d'impression précédente, de sorte que les deux extrémités de l'autre section formant filet (6) rencontrent un milieu d'impression auparavant imprimé et déjà séché.

7. Procédé pour l'impression d'au moins un filet précis selon au moins l'une des revendications précédentes, **caractérisé en ce que** le chevauchement entre une section formant filet (4) auparavant imprimée et une autre section formant filet (6) d'une autre couche d'impression est compris entre 1 et 3, de préférence entre 1 et 2 et de manière particulièrement préférée exactement 1 champ ou un nombre correspondant de gouttes de milieu d'impression (3).

8. Procédé pour l'impression d'au moins un filet précis selon au moins l'une des revendications précédentes, **caractérisé en ce que** l'impression complète d'un filet précis (1) et de préférence de toute la surface du substrat est effectuée en plusieurs couches d'impression constituées de premières sections formant filet et d'autres sections formant filets (4, 6).

9. Procédé pour l'impression d'au moins un filet précis selon au moins l'une des revendications précédentes, **caractérisé en ce que** l'impression est effectuée dans toutes les couches d'impression et/ou dans toutes les sections formant filets (4, 6) au moyen du même milieu d'impression, en particulier un vernis durcissable.

10. Procédé pour l'impression d'au moins un filet précis selon au moins l'une des revendications précédentes, **caractérisé en ce que** l'impression de toutes les gouttes de milieu d'impression (3) d'une couche d'impression le long d'une course de buse (2) est effectuée au moyen de la même buse de tête d'impression **et/ou en ce que** les sections formant filets (4, 6) d'une course de buse sont imprimées dans chaque couche d'impression respectivement avec une buse de tête d'impression différente.
